(19) Europäisches Patentamt
European Patent Office
Office européen des brevets

(11) **EP 2 521 178 A1**

(12) **EUROPEAN PATENT APPLICATION**
published in accordance with Art. 153(4) EPC

(43) Date of publication:
**07.11.2012 Bulletin 2012/45**

(51) Int Cl.:
***H01L 27/144*** *(2006.01)*       ***H04N 5/335*** *(2011.01)*

(21) Application number: **10852352.3**

(22) Date of filing: **01.06.2010**

(86) International application number:
**PCT/CN2010/073442**

(87) International publication number:
**WO 2011/150553 (08.12.2011 Gazette 2011/49)**

(84) Designated Contracting States:
**AL AT BE BG CH CY CZ DE DK EE ES FI FR GB
GR HR HU IE IS IT LI LT LU LV MC MK MT NL NO
PL PT RO SE SI SK SM TR**

(71) Applicant: **Boly Media Communications
(Shenzhen) Co., Ltd
Shenzhen, Guangdong 518067 (CN)**

(72) Inventor: **HU, Xiaoping
Guangdong 518067 (CN)**

(74) Representative: **Manitz, Finsterwald & Partner
GbR
Martin-Greif-Strasse 1
80336 München (DE)**

(54) **PHOTOSENSITIVE DEVICE AND READING METHOD AND READING CIRCUIT THEREOF**

(57)     The present application relates to a photosensitive device as well as a reading method and a reading circuit thereof. The photosensitive device comprises a pixel array and a read circuit, wherein a transfer gate for connecting adjacent pixels and transferring charge between the connected pixels is arranged among at least some designated pixels in the pixel array, the read circuit is used for reading charge of a pixel in the pixel array, said charge is at least one of self-charge of said pixel, charge transferred from an adjacent pixel of said pixel, superposition of the self-charge of said pixel and the charge transferred from one or more pixels adjacent to said pixel, and superposition of the transfer charges of two or more pixels adjacent to said pixel.

Figure 22

# Description

## Technical Field

The present disclosure relates to photosensitive devices as well as methods and circuits for reading the same, especially to methods for designing, manufacturing and reading photosensitive pixels in large-array photosensitive chips which have high performance as well as semiconductor processes for fabricating the same. According to the present disclosure, a new photosensitive device is provided by combining matured CCD photosensitive chip techniques with matured CMOS photosensitive chip techniques.

## Background

The present disclosure is a continuation of applications titled "Multi-spectrum Photosensitive Devices and Methods for Manufacturing the Same" (PCT/CN2007/071262), "Multi-Spectrum Photosensitive Devices and Methods for Manufacturing the Same" (China Application No. 200810217270.2), and "Multi-Spectrum Photosensitive Devices and Methods for Sampling the Same" (China Application No. 200910105948.2) filed by the present inventor(s), and aims at providing more specific and preferable semiconductor circuit-level and chip-level implementations, and even a new semiconductor manufacturing technology suitable for photosensitive devices.

It is well known that traditional photosensitive chips technologies mainly comprise CCD (charge coupled devices) technologies and CMOS (complementary metal-oxide semiconductors) technologies. Although other semiconductor technologies, such as a cadmium indium based semiconductor technology ("Silicon infrared focal plane arrays", M. Kimata, in Handbook of Infrared Detection Technologies, edited by M, Henini and M. Razeghi, pp. 352-392, Elsevier Science Ltd., 2002), may also be used to manufacture chips for sensing infrared light, they are not widely used.

CCD and CMOS are essentially based on silicon-based semiconductor technologies, and different from each other mainly in methods for reading pixels therein. Due to the different reading methods, CCD semiconductor processes deviate from traditional CMOS semiconductor processes and become a special branch in the semiconductor technologies, i.e., CCD semiconductor technology.

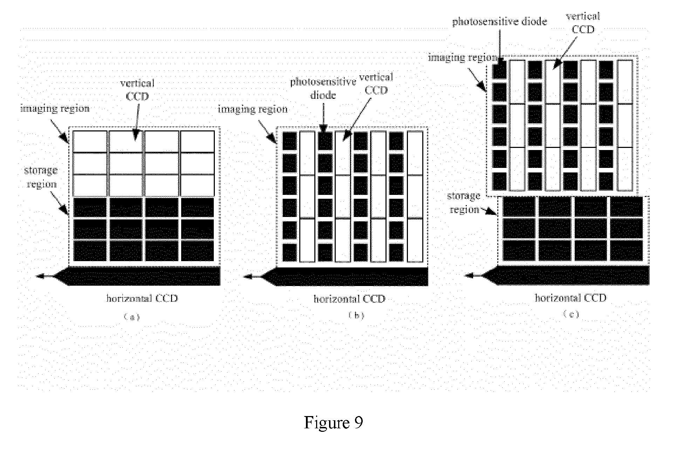

Pixels in CCD photosensitive chips are mainly read with the following three methods: a Frame Transfer method as shown in Figure 9(a), an Inter-line Transfer method as shown in Figure 9(b), and a Frame Inter-line Transfer method as shown in Figure 9(c). All of the above three methods require that charges are transferred with a high speed and a high fidelity between photosensitive pixels or between a photosensitive pixel and a non-sensing photo-transfer pixel, which results in the following characteristics of the CCD semiconductor processes: (1) a high voltage, generally about ±18V; (2) a high purity, i.e., high consistency among pixels; (3) a high processing precision, for example, size, depth, etc, for pixels must be almost identical. The complexity and non-standard nature of the CCD fabricating process lead to high cost of CCD devices, so that it is difficult to integrate the photosensitive devices with processing devices. Furthermore, high voltage also leads to high power consumption for CCD devices.

Similar to DRAM, row-selecting controllers and column-selecting controllers in CMOS puts each pixel voltage onto a reading bus one by one directly, and pixel signals are read in turn by using row selecting and column selecting signals. It is advantageous that the semiconductor process for fabricating such photosensitive devices is very close to the standard CMOS process and thus the photosensitive devices may be manufactured in most standard semiconductor factories so to attain low cost. It is also advantageous that the operation is under a low voltage which leads to low power consumption. The CMOS photosensitive chip technology has surpassed CCD technology in primary technical aspects and becomes the most widely used photosensitive chip technology today due to rapid development of CMOS photosensitive chip technology.

In addition, a pixel in CMOS photosensitive chip may be designed as a passive pixel or an active pixel. Since the active pixel has a higher SNR and sensitivity, it is more widely used than the passive pixel. However, a reading capacitor FD (Floating Diffusion) and a 3T, 4T or even 5T/6T sampling amplifier need to be used in the active pixel, resulting in a reduced fill factor of photosensitive area. The number of effective pixels in a unit area is thus decreased, preventing a further improvement of the SNR and sensitivity. Thus, a shared reading circuit such as a 4T active pixel shared by 4 points is developed recently. Generally, a shared reading capacitor FD is also used when a shared reading circuit is used, which may have some disadvantages. Firstly, a block of dead pixels will occur if one reading capacitor or one component in the reading circuit is fault. Moreover, cross talking among pixels of different colors is increased by the shared reading capacitors, which results in a fact that the colors will not be vivid enough.

Another problem of CMOS reading technology is that a pixel clock with a very high frequency is required to obtain a suitable frame rate in the case of a large pixel array. However, the pixel clock is limited by conditions such as the AD converting speed.

Therefore, improvements to either the CCD photosensitive chip technology or the CMOS photosensitive chip technology are desired.

## Summary

### Technical Problem

The object of the present application is to provide a new-type photosensitive device, which incorporates advantages of CCD and CMOS photosensitive devices and thus has convenience in processing, reading, and etc, as well as a method for reading the same.

### Technical Solution

According to an aspect of the present application, a photosensitive device comprising a pixel array and a reading circuit is disclosed, wherein a transfer gate for connecting adjacent pixels and transferring charge between the connected pixels is arranged among at least some designated pixels in the pixel array, the read circuit is used for reading charge of a pixel in the pixel array, said charge is at least one of self-charge of said pixel, charge transferred from an adjacent pixel of said pixel, superposition of the self-charge of said pixel and the charge transferred from one or more pixels adjacent to said pixel, and superposition of the transfer charges of two or more pixels adjacent to said pixel.

The adjacent pixels connected to one pixel in said some designated pixels via the transfer gate comprise four adjacent pixels which are above, below, leftward and rightward to said one pixel respectively.

In the photosensitive device, a transfer gate is arranged between every two pixels of the pixel array.

In the photosensitive device, the reading circuit reads the self-charge of a pixel connected thereto, resets the self-charge of the pixel, and then reads the charge transferred from pixels adjacent to the pixel.

In the photosensitive device, the reading circuit includes an active pixel reading circuit, a passive pixel reading circuit, or a hybrid active-passive pixel reading circuit.

In the photosensitive device, the active pixel includes a 3T, 4T, 5T, or 6T active pixel.

In the photosensitive device, the reading circuit is shared by 4, 6, 8 or arbitrary number of points (i.e., pixels) or not shared by points.

In the photosensitive device, a transfer distance from a pixel in a set of pixels sharing but not directly connected to a same reading circuit to a pixel in the set which is directly connected to the reading circuit is not longer than four pixels when the reading circuit is shared by 4, 6, 8 or arbitrary number of points.

The photosensitive device comprises a single-sided single-layer photosensitive device, a single-sided double-layer photosensitive device, a single-sided multi-layer photosensitive device, a double-sided double-layer photosensitive device, and a double-sided multilayer photosensitive device.

The photosensitive device is sensitized in a method of front sensing, back sensing or double-sided sensing.

In the photosensitive device, pixels in the pixel array are repeatedly arranged according to a preset pattern for sensing single color, multi-color, or multi-spectrum including visible light and infrared light.

In the photosensitive device, the preset pattern includes Bayer pattern, honeycomb pattern, single color pattern or CyYeMgX pattern wherein X is any one of R (red), G (green), and B (blue).

According to another aspect of the present application, a reading method for a photosensitive device is disclosed, which includes steps of:

arranging among at least some designated pixels in a pixel array a transfer gate for connecting adjacent pixels and transferring charge between the connected pixels;

reading charge of a pixel in the pixel array, wherein the charge is at least one of self-charge of said pixel, charge transferred from an adjacent pixel of said pixel, superposition of the self-charge of said pixel and the charge transferred from one or more pixels adjacent to said pixel, and superposition of the transfer charges of two or more pixels adjacent to said pixel.

According to the reading method, the charge transferred from pixels adjacent to the pixel is read out after the self-charge of the pixel is read out and reset.

The reading method may further include a sampling and sub-sampling process, which comprises: a first combining process for combining-and-sampling two neighboring pixels in the pixel array which are in a same row but different columns, different rows but a same column, or different rows and different columns to obtain sampling data of a first combined pixel; and a second combining process for combining-and-sampling the sample data of the first combined pixel obtained in the first combining process to obtain sampling data of a second combined pixel.

The reading method may further include a third combining process for combining-and-sampling the sampling data of the second combined pixel obtained in the second combining process to obtain sampling data of a third combined pixel.

According to the reading method, the first or second combining process is performed by a charge superposition of pixels with same or different colors or a signal averaging of pixels with different colors, wherein pixels with different colors are combined according to a color space conversion to meet requirements of color reconstruction.

According to the reading method, combining-and-sampling based on color performed in the first or the second combining process includes same-color combining, different-color combining, hybrid combining, or selectively abandoning redundant colors, and at least one of the first and the second combining process is not performed by the same-color combining.

According to the reading method, combining-and-sampling based on position performed in the first or the second combining process includes at least one of automatic averaging of signals output directly to a bus, row skipping or column skipping, and one-by-one sampling.

According to the reading method, the third combining process is performed by at least one of color space conversion and backend digital image scaling.

According to the reading method, the color space conversion includes a conversion from RGB to CyYeMgX space, a conversion from RGB to YUV space, or a conversion from CyYeMgX to YUV space, wherein X is any one of R (red), G (green) and B (blue).

According to the reading method, sampling of a whole image is performed by progressive scanning progressive reading or progressive scanning interlacing reading.

According to a further aspect of the present application, a reading circuit of a photosensitive device for reading charge of a pixel in a pixel array of the photosensitive device is disclosed, wherein a transfer gate for connecting adjacent pixels and transferring charge between the connected pixels is arranged among at least some designated pixels in the pixel array, the read circuit is used for reading charge of a pixel in the pixel array, said charge is at least one of self-charge of said pixel, charge transferred from an adjacent pixel of said pixel, superposition of the self-charge of said pixel and the charge transferred from one or more pixels adjacent to said pixel, and superposition of the transfer charges of two or more pixels adjacent to said pixel.

The reading circuit connected to at least some designated pixels in the pixel array is a hybrid reading circuit of both active pixel and passive pixel.

The reading circuit is provided with a pixel clear or reset signal.

Technical Effects

The present application has the following advantages:

1. According to the photosensitive device of the present application, a transfer gate is arranged among at least a part of pixels in the pixel array so that charge may be transferred between two pixels. The read circuit may reads from a pixel in the pixel array self-charge of said pixel, charge transferred from an adjacent pixel of said pixel, superposition of the self-charge of said pixel and the charge transferred from one or more pixels adjacent to said pixel, and superposition of the transfer charges of two or more pixels adjacent to said pixel. Thus, the following can be achieved:

(1) Only a low reading voltage is required. Since the charge transfer only occurs between pixels adjacent to each other, a high voltage is not required and a reduced power consumption of the photosensitive device is achieved.

(2) Fabricating process is simplified and photosensitivity is improved. Since the charge transfer occurs between pixels, a reading capacitor is not necessary to be provided in the photosensitive device of the present application, which leads to increase of photosensitive area so that the photosensitivity is improved. Meanwhile, fabricating process may be simplified due to the omission of the reading capacitor. In addition, since the charge transfer only occurs between pixels adjacent to each other, even if some deviation is induced by non-identity among pixels, accumulation of such deviation will not be too high, such that the requirement to identity among pixels and processing accuracy may be reduced.

(3) Flexibility of selecting active or passive pixels is provided. The advantage of active pixels is a high SNR, while that of passive pixels is low power consumption. However, it is usually difficult to make a compromise between advantages of the active and passive pixels. In the present application, charge superposition is performed during sub-sampling by charge transfer so that signal enhance is achieved during the sub-sampling. Therefore both advantages of active and passive pixels can be made use of. The high power consumption of active pixel is largely due to arrangement of an amplifying circuit. In the present application, however, active pixels are only used when taking full frame photographs. Passive pixels without an amplifying circuit are used for previewing and sub-sampled images. Therefore a high SNR is obtained when taking high-pixel photographs with reduced power consumption in normal use, so that the advantages of active and passive pixels are combined according to the present application.

The present application proposes a concept of "adjacent pixel" from the perspective of reading circuit sharing and pixel transferring. Generally speaking, pixels are divided into some small groups according to a spatial distribution, each of which may share one or more reading circuits. Pixel combination is only performed within each group. Generally, the pixels in a same combination group are generally referred to as adjacent pixels.

In the present application, pixels are only transferred between two pixels adjacent to each other in the horizontal or vertical direction. Thus, if one pixel is needed to be transferred to a non-neighboring pixel, the transfer needs to be further delivered. The number of transfer times is referred to as a "transfer distance". Taking a 4-point pixel array as an example, if charge should be transferred into the pixel at top-left corner of the array, charge of the top-right pixel is transferred to the top-left pixel by only one transferring between pixels in the same row; and charge of bottom-left pixel is transferred to the top-left pixel by only one transferring between pixels in the same column. That is, the transfer distances from both the top-right pixel and the bottom-left pixel to the top-left pixel are 1. As for a bottom-right pixel, its charge is transferred firstly to the bottom-left pixel by one transferring between pixels in the same row or to the top-right pixel by one transferring between pixels in the same column, and then to the top-left pixel via the top-right pixel or the bottom-left pixel, i.e., the distance from the bottom-right pixel to the top-left pixel is 2. That is to say, for a pixel nonadjacent to the transfer target pixel, charge of the pixel may be transferred to the transfer target pixel only when an adjacent pixel acts as medium. It should be noticed that the transfer direction is not limited in the present application, i.e., charge of a pixel may be transferred to its adjacent pixels in any direction. To avoid the control circuit to be too complicated, the transfer distance should not be larger than four pixels.

The above-mentioned description is mainly aimed at transferring two-dimensional pixels. For a multilayer photosensitive device, photosensitive pixels on different layers in a same light direction may be transferred similarly to the above method too.

When reading charge, a reading circuit may read from a pixel its self-charge or the charge transferred from a pixel adjacent thereto. Generally, for a transfer target pixel meant to be a transfer destination, if its photosensitive signal is not lost, the self-charge of the pixel may be read first, and then the pixel is reset followed by transferring the charge of an adjacent pixel to this transfer target pixel. In this method, unity of charge is maintained, but the unity is not necessary. During reading, it is also possible to superpose charges and then reading the charge superposition. The charge superposition may be a superposition of the self-charge of the target pixel and charge transferred from a pixel adjacent thereto, and may also be a superposition of charges transferred from two or more pixels to the transfer target pixel. The superposition of pixels with a same color is not a requirement. However, for pixels of different colors, in order to meet the requirement of color reconstruction, pixels of only two colors may be superposed generally.

The reading circuit may be not shared between pixels. Preferably, a multi-pixel sharing mode may be used, i.e., a reading circuit may be arranged above the transfer target pixel, and charge of pixels adjacent to the transfer target pixel is read by transferring the charge to the transfer target pixel firstly and then reading the charge by the reading circuit arranged above the transfer target pixel. Herein, the transfer target pixel and adjacent pixels thereof sharing a reading circuit are referred to as a pixel group.

Since advantages of both active and passive pixel have been combined in pixels of the present application, when appropriate, for each pixel in the pixel array connected to a reading circuit, the reading circuit may be an active pixel reading circuit, a passive pixel reading circuit, or a reading circuit including both active and passive pixel reading circuits such that each pixel may have reading function of both active and passive pixels by selectively connecting to active or passive pixel reading circuit by a signal selection.

In conclusion, the advantages of CCD and CMOS photosensitive chip technologies are combined in the present application, so that a more advanced photosensitive device is implemented physically in a more superior way.

A pixel reading of charge transfer between pixels, in particular, between two-dimensional pixels (2D pixel transfer) is provided in the present application for the first time. Thus, a pixel without a reading capacitor FD is achieved and the combination of active and passive pixels is implemented. The combination of charge signals is achieved without a reading capacitor FD.

Combining and sampling in almost all sub-samplings of prior arts is performed by averaging voltage or current signals, in which SNR may be increased by up to $\sqrt{N}$ times when N points are combined. However, the SNR may be increased by $N\sqrt{N}$ times when charge superposition is employed, which is N times higher than signal averaging. That is to say, if N signals are combined by charge superposition, an effect of averaging with up to $N^3$ signals will be obtained theoretically. Thus the SNR may be improved significantly.

The sub-sampling with any M×N factors is easily accomplished in the present application by a sub-sampling mode in which charge superposition is primary and signal averaging is supplementary.

According to the present application, the reading circuit may easily extended from 4-point sharing, 8-point sharing and etc, to arbitrary N-point sharing based on the requirement of design optimization, owing to the omission of reading capacitor FD.

In the present application, sub-sampling process is divided into at least two processes, i.e., the aforementioned first combining-and-sampling process and second combining-and-sampling process. The first and second combining-and-sampling processes are usually conducted between row (combining) sampling and column (combining) sampling of pixels, and mainly conducted to analog signals, in which the order and contents are generally changeable except that the charge superposition is usually only performed in the first combining-and-sampling process. In addition, a third combining-and-sampling process, which is conducted mainly to digital signals after analog-to-digital conversion, may be further included.

In the first combining-and-sampling process, two neighboring pixels in the pixel array are combined. On one hand, combination of neighboring pixels is accomplished. Herein, the pixel obtained after the combination is referred to as a first combined pixel. It should be understood that the concept of the first combined pixel is used to indicate the pixel obtained after the first combining process for the convenience of description. It does not intend to indicate that a "first combined pixel" physically exists in pixel array. The data obtained by the combining and sub-sampling for two neighboring pixels is referred to as sampling data of the first combined pixel. The term of "neighboring" used herein means that the two pixels are abutting when viewed from horizontal, vertical, or diagonal direction with no other pixels interposed therebetween. The cases of neighboring include two pixels being in a same row but different columns, different rows but a same column, or different rows and different columns. Generally speaking, in this combining, a signal is obtained by average of at least two signals so that a noise will be reduced $\sqrt{N}$ times. Therefore, SNR will be increased by at least $\sqrt{N}$ times after the combining, and the combination may be performed between pixels with same or different colors. On the other hand, pixels to be combined may have different colors, i.e., addition or average of colors is performed. As known from the three primary colors theory, a color formed by adding two primary colors is complementary with the other primary color. Only a color space conversion is required to transfer from a primary color space to a complementary color space. Thus, color reconstruction may also be accomplished by different complementary colors. In other words, the combination of pixels with different colors may be accomplished to improve SNR and the color reconstruction may also be implemented according to the present application. The whole sub-sampling process is optimized so as to meet the high-speed requirement of pixel array with large amount of data. A basic demand for color space conversion is that the combination of colors after conversion is capable of reconstructing the required RGB (or YUV, or CYMK) colors (by interpolation technique and matrix operation etc.).

It should be realized that a plurality of pixels are contained in the pixel array but only two pixels are combined in the first combining-and-sampling. Obviously, a plurality of first combined pixel will be formed by the combining. For different first combined pixels, the color combining methods used may be the same or different. The first combining process is referred to as a same-color combining mode when it is completely performed between pixels having a same color. The first combining process is referred to as a different-color combining mode when it is completely performed between pixels having different colors. The first combining process is referred to as a hybrid combining mode when it is performed partly in pixels having a same color and partly in pixels having different colors. The first combining process is referred to as selectively abandoning redundant colors mode when some redundant color pixels in a pixel array is abandoned or skipped (certainly, such abandon is selective and will not affect color reconstruction for example).

Obviously, the second combining process is an operation to the plurality of first combined pixels. Similarly, it is possible to combine the first combined pixels with same or different colors (of course, it may lead to that all the three primary colors are added so that the color reconstruction cannot be accomplished).

The above-mentioned modes of combining, i.e., the same color combining, the different color combining and the hybrid combining are classified based on color. In addition, from the perspective of position selection of the combining and sampling, the combining and sampling modes of the first and second combining process include: automatic averaging of signals output directly to a bus, row skipping or column skipping, one by one sampling, and combination of two or three of these modes. Except that the charge superposition is only performed in the first combining-and-sampling process, the first and second combining process are the same and changeable (except for their different order).

The mode of so-called automatic averaging of signals output directly to a bus is that signals (same color or different colors) to be combined are simultaneously output to a data collection bus by automatic balance of (voltage) signals to achieve an average value of the signals to be combined. The mode of row skipping or column skipping is that some rows or columns are skipped when implementing the (combining) sampling so that a reduced volume of data is processed. The mode of one by one sampling is that original pixels or the first combined pixel are readout in turn without any combination. More than one of the three modes may be employed simultaneously. For example, the mode of row skipping or column skipping can be used at the same time with the mode of automatic averaging of signals output directly to a bus or the mode of one by one sampling.

The sub-sampling mode of third combining-and-sampling process includes color space conversion, backend digital image scaling and a serial use of the two modes. The first and second combining process are mainly conducted to analogue signals, while the third combining process is mainly conducted to digital signals, i.e., after analog-to-digital conversion. Through treating three or four color pixels at different spatial locations as values for one same point and transferring the values to another color space, data in horizontal and (or) vertical direction will decrease to achieve the effect of sub-sampling. Moreover, the digital image scaling mode is the most intuitive sub-sampling mode which is commonly used.

Charge superposition is a combining-and-sampling mode with significant effect, in which pixels to be combined are required to be adjacent spatially. The reason why such effect cannot be achieved by previous sub-sampling is that the previous sub-sampling is only performed between pixels with a same color and the pixels to be combined are separated by other pixels in between. It is relatively easy to implement charge superposition for a multilayer photosensitive device because its color patterns are very rich. An earlier application "Multi-Spectrum Photosensitive Device and Sampling Method Thereof" (Chinese Patent Application No. 200910105948.2) of the present inventor proposed a sub-sampling mode of charge superposition by using a color space conversion for the first time. However, in many cases, the pixel combination is wholly or partly performed on pixels having different color. Furthermore, for some special sub-sampling factors (M×N), row skipping and column skipping modes are also needed after the color space conversion.

According to the present application, fabrication of pixel array is simplified, while the reading circuit becomes more flexible and simpler. Especially, sub-sampling may be carried out on pixels having a same color by charge superposition. This characteristic is of particular value for improving performance of a photosensitive device under low illumination condition. If necessary, the sensitivity may be multiplied by sacrificing resolution. For example, if four pixels with a same color are combined by charge superposition, an improved upper limit of SNR is $4\sqrt{4}=8$ times theoretically, while if four pixels are combined by previous signal averaging method, the improved upper limit of SNR is $\sqrt{4}=2$ times in theory.

For those skilled in the art, the above and the other purposes and advantages of the present application will become apparent with the following descriptions and a plurality of illustrations of preferred embodiments with reference to the accompanying drawings as shown below.

Drawings

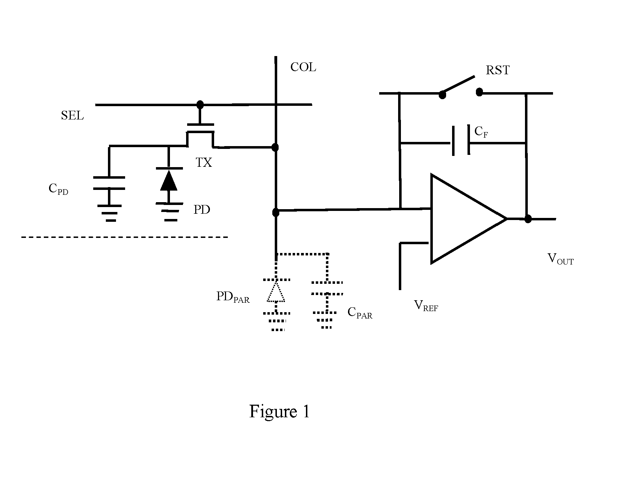

Figure 1 illustrates a reading (sampling) circuit for a CMOS passive pixel.

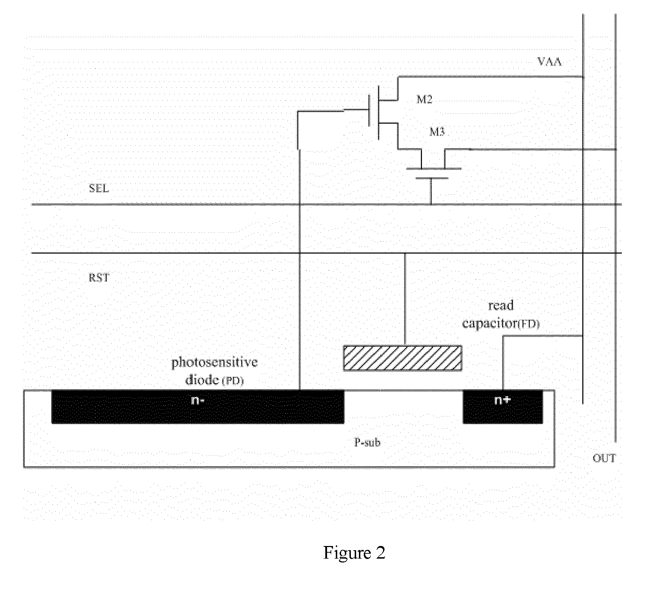

Figure 2 illustrates a reading (sampling) circuit for a CMOS 3T active pixel, wherein PD is a photosensitive diode and FD is a non-sensing transfer reading capacitor.

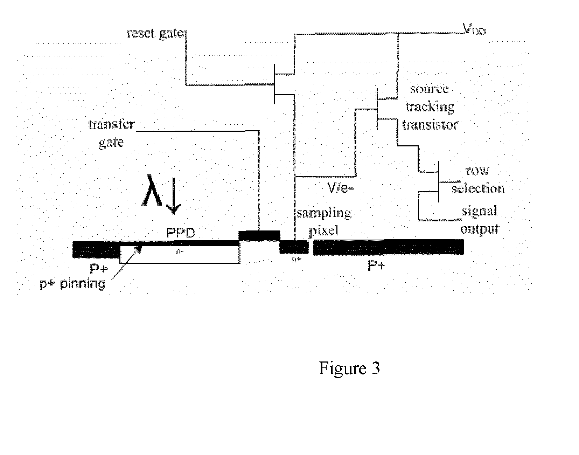

Figure 3 illustrates a reading (sampling) circuit for a CMOS 4T active pixel.

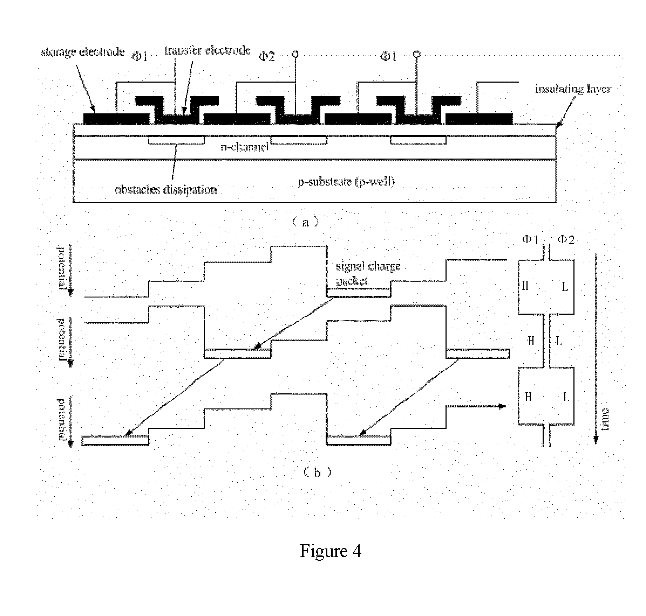

Figure 4 illustrates a pixel design for a two-phase CCD (Figure 4(a)) and a schematic of a charge transfer process (Figure 4(b)), wherein Figure 4(a) is a cross-section view of the two-phase CCD, and Figure 4(b) shows a channel potential under two-phase pulses Φ1 and Φ2.

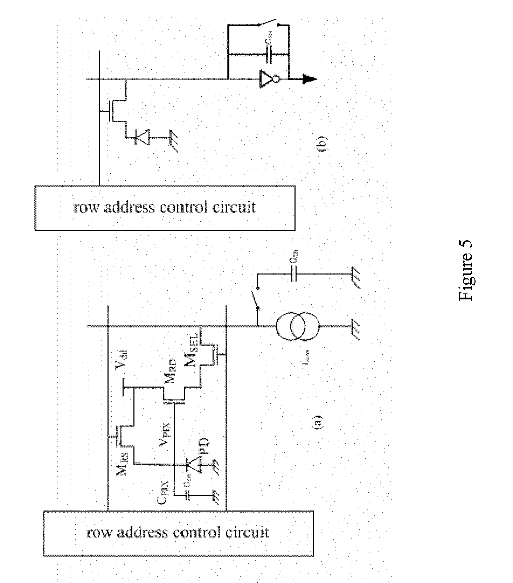

Figure 5(a) is a schematic diagram of a row selection reading circuit for a CMOS active pixel, and Figure 5(b) is a schematic diagram of a row selection reading circuit for a CMOS passive pixel.

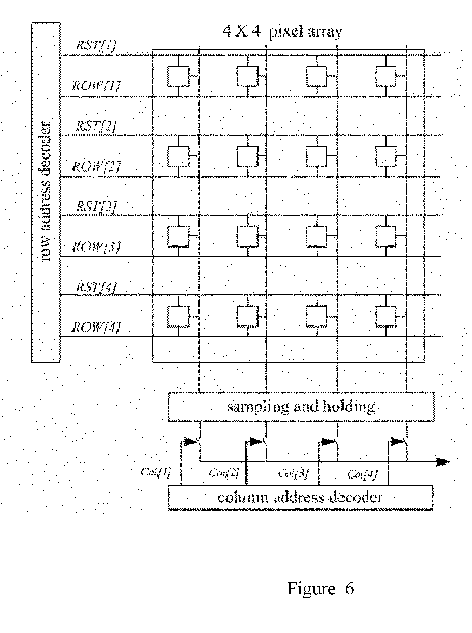

Figure 6 is an abstractive representation of a general reading circuit for the CMOS reading circuits as shown in Figure 5.

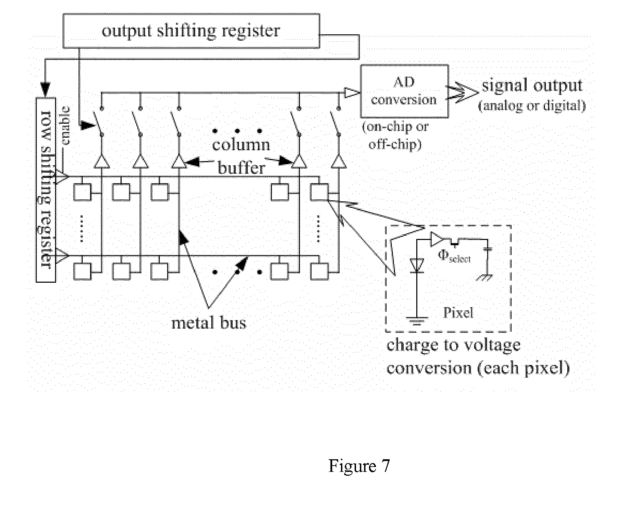

Figure 7 illustrates a typical schematic diagram of a reading (sampling) circuit having column buffers for a practical CMOS pixel.

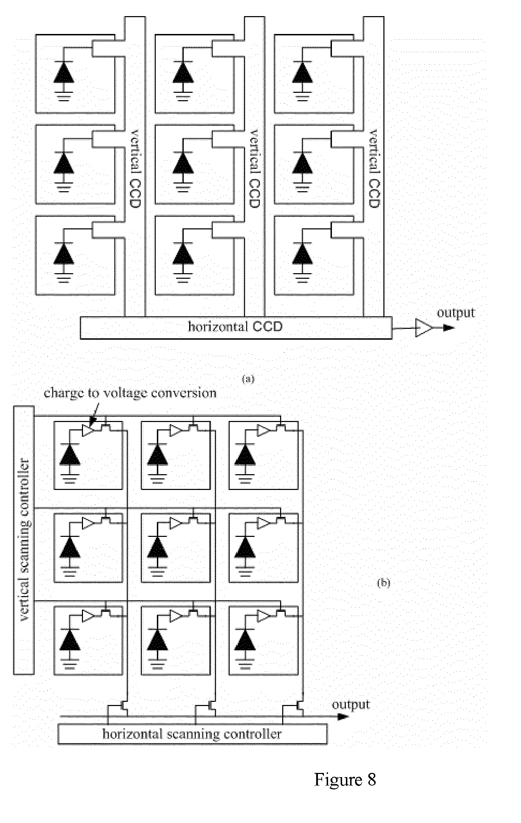

Figure 8 illustrates a comparison between a reading method of a CCD pixel (a) and a reading method of a CMOS pixel (b), in which the function of successive transmission in a vertical direction among CCD pixels is shown in Figure 8(a).

Figure 9 illustrates main principles of three mainly used CCD photosensitive devices. Figure 9(a) shows a frame transfer CCD (FTCCD) in which pixels in a photosensitive region are transferred row by row to a storage region and then read out pixel by pixel through a horizontal CCD. This kind of CCD has a problem of image smearing. Figure 9(b) shows an inter-line transfer CCD (ITCCD) in which pixels in the photosensitive region are transferred simultaneously to the inter-column storage region and then read out row by row through the horizontal CCD. The image smearing problem is relieved in this kind of CCD, but a large number of inter-column storages are used. Figure 9(c) shows a frame inter-line transfer CCD (FITCCD) in which pixels in the photosensitive region are firstly transferred to the inter-column storage region. Then, pixels in the inter-column storage region are transferred row by row to a frame storage region. Finally, pixels in the frame storage region are read out row by row through the horizontal CCD. This kind of CCD is mainly used in professional high speed video cameras for further relieving the image smearing.

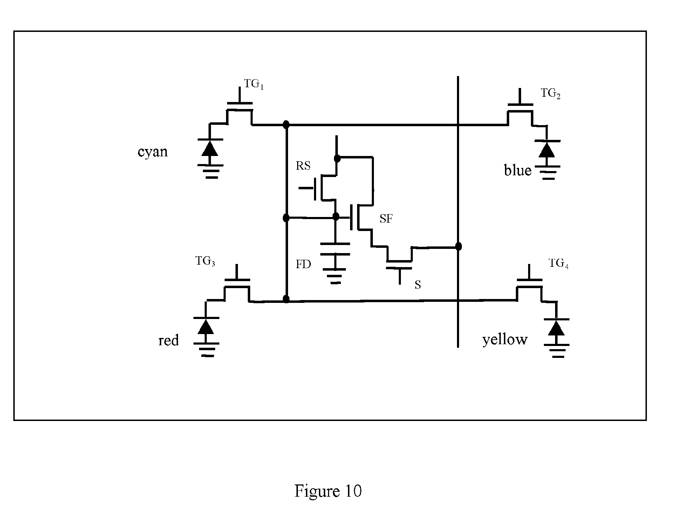

Figure 10 illustrates a currently used reading circuit for a 4T active photosensitive pixel shared by 4 points, wherein 1.75 gates in average are used for each pixel in average.

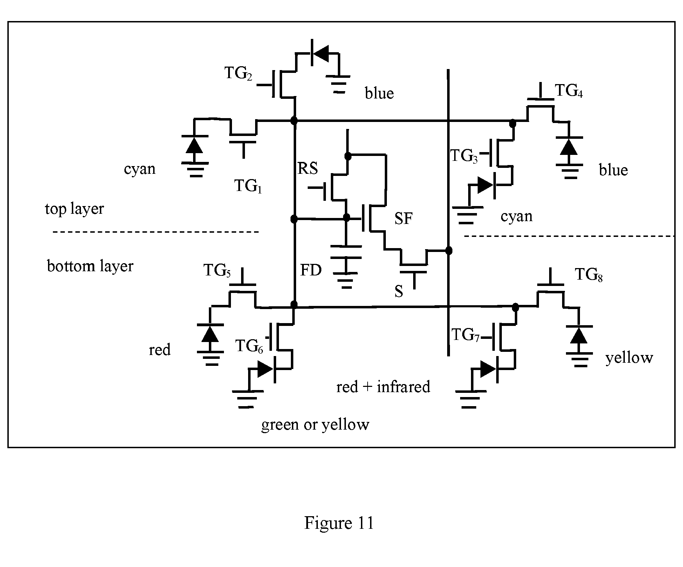

Figure 11 illustrates a reading circuit for a 4T active photosensitive pixel shared by 8 points, wherein only 1.375 gates in average are used for each pixel. This reading circuit is suitable for a double-sided double-layer photosensitive device arranged in an array based on four-point macro-pixels (referring to Chinese Patent Application No. 200810217270.2 titled "Multi-spectrum Sensing Devices and Methods for Manufacturing the Same"), i.e., photosensitive diodes in both upper and lower layers of all four composite pixels in a macro-pixel may share a same reading capacitor (FD) and a same 3T reading circuit.

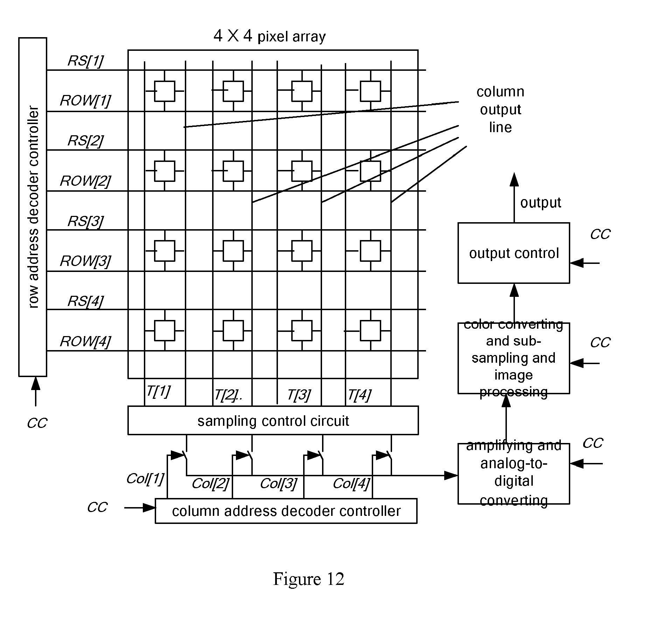

Figure 12 illustrates a principle system block schematic of a circuit for reading and sub-sampling pixels provided in Chinese Patent Application No. 200910105948.2 titled "Multi-Spectrum Photosensitive Devices and Methods for Sampling the Same" which is also filed by the present inventor, which comprises a pixel array, a row address decoding controller, a column address decoding controller, a sampling control circuit, an amplifying and analog-to-digital converting module, a color converting and sub-sampling and image processing module, an output control module, a central chip control module (CC module in Figure 12), and other possible modules. The pixel reading and sub-sampling are achieved by corresponding control signals generated by the row and column address decoding controllers. Cooperation of other modules in the system is mainly achieved by the central chip control module. In this reading circuit, charges corresponding to signals are superposed during a sampling process for the first time by means of color spatial converting, such that the SNR of sub-sampled images is largely increased. In this Figure, Row[i] indicates a row selection signal, RS[i] indicates a row control vector signal, Col[j] indicates a column selection signal, and T[j] indicates a column control vector signal. In this system, the color converting and sub-sampling and image processing module may be used for implementing a third combined sampling process of the present disclosure.

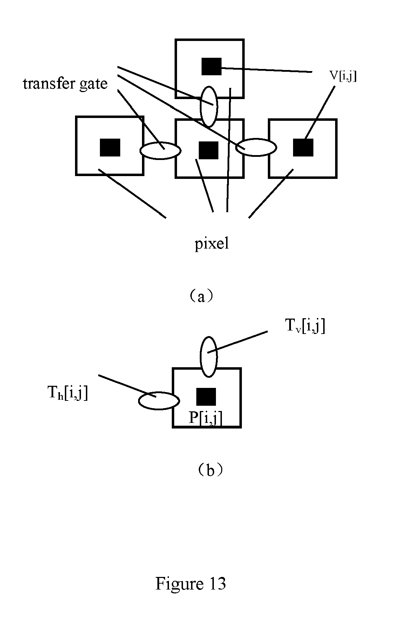

Figure 13(a) illustrates a principle schematic diagram of photosensitive pixels for 2D pixel transfer according to the present disclosure. The photosensitive pixel has a function of transferring charges to nearby pixels (at least in three directions). In short, each pixel may act as a reading capacitor FD of its nearby pixels. That is to say, pixel transfer function of CCD in one dimension (in a vertical or horizontal direction) is extended to two-dimensional, i.e., charges may be transferred in both vertical and horizontal directions. Different from CCD, pixels (charges) are only transferred between pixels close to each other, but not transferred far away (such as a distance of one row or one column of CCD). The pixels are also read out by using active row and column scanning of CMOS. Thus, advantage of CCD (requiring no FD) and that of CMOS (randomly reading and low-voltage) are combined in this photosensitive pixel. Each pixel is coupled with a voltage control signal V[i, j] (shadowed blocks in pixels as shown in this Figure are metal electrodes which are very thin).

Figure 13(b) illustrates reference numbers of pixels and transfer gates used herein for simplifying description of the present disclosure: transfer gates on the left and top of each available pixel (i.e., non-edge pixel) are regarded as belonging to the pixel and denoted with the row and column address number [i, j] of that pixel.

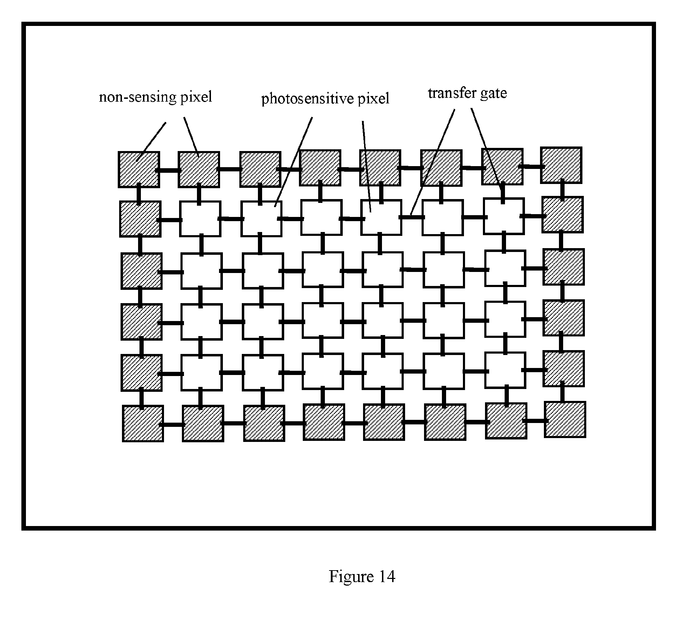

Figure 14 is a schematic diagram of a photosensitive pixel array consisted of photosensitive pixels for 2D pixel transfer according to the present disclosure. It should be noted that charge transfer between pixels may occur between pixels with different colors.

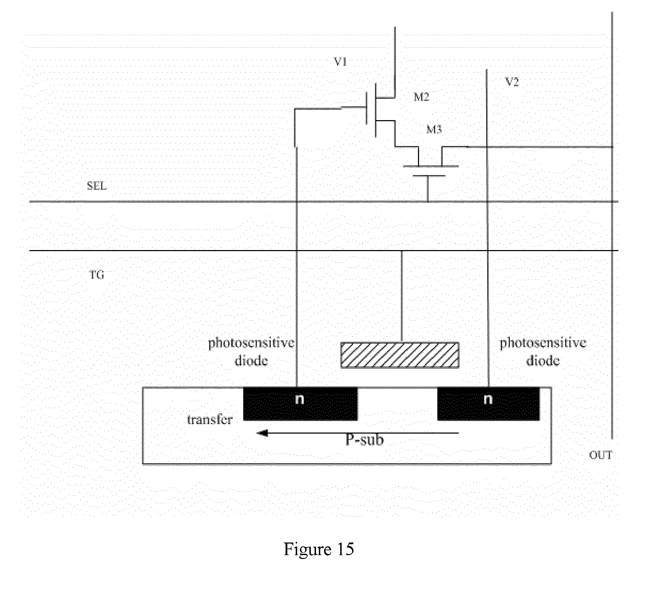

Figure 15 illustrates a schematic diagram of a semiconductor implementation of the photosensitive pixel for 2D pixel transfer according to the present disclosure. Figure 15 differs from Figure 2 in that no FD exists. An adjacent pixel (PD) acts as a reading capacitor (FD). Only one 3T (active pixel) reading circuit is shown in Figure 15. However, it is possible that one reading circuit is provided for each pixel or shared by several pixels depending on sharing situation of the reading circuit. This implementation is similar to the current CMOS photosensitive pixel.

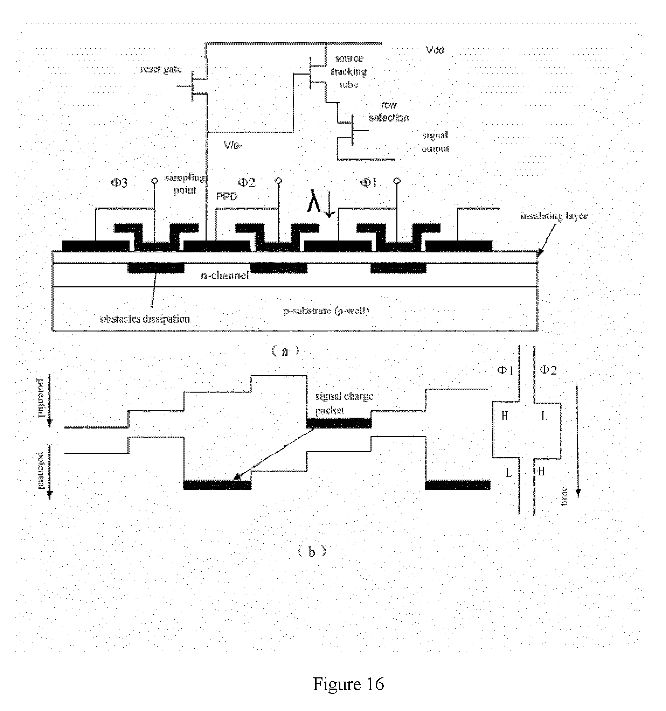

Figure 16 illustrates a schematic diagram of another semiconductor implementation of the photosensitive pixel for 2D pixel transfer according to the present disclosure, as well as a timing sequence of the charge transfer. Figure 16(a) shows a cross-section of the photosensitive device according to the present disclosure and a reading circuit which is similar to Figure 4(a) except that a reading circuit of a 4T active pixel is added. Figure 16(b) shows a channel potential under transfer pulses $\Phi 1$ and $\Phi 2$, which is similar to Figure 4(b), except that transferred charge may not be further transferred along one direction (horizontal direction) all the way forward. In the next clock period, charge transfer direction may be changed (for example, from horizontal to vertical direction). Alternatively, it is also possible to start reading pixel in the next clock period. Similarly, the reading circuit for active pixel(s) may be shared by several pixels or not.

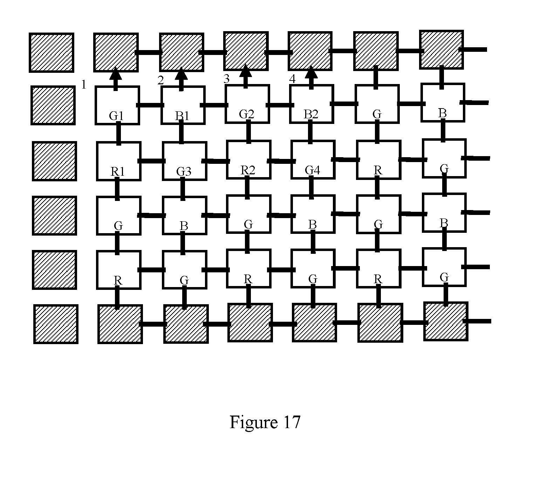

Figure 17 illustrates a schematic diagram of a full frame reading for a photosensitive device consisted of photosensitive pixels for 2D pixel transfer according to the present disclosure. In this simple reading, pixels in a first row (preceding row) are used as reading capacitor FD of pixels in a second row which is next to the first row. Before reading a pixel in the second row, a corresponding pixel in the first row is reset and a correlated sampling (zero potential sampling) is performed thereto. After that, the pixel in the second row is transferred to the first row and then the photosensitive charge (voltage) is sampled. The numerals 1, 2, 3, and 4 in Figure 17 indicate a sequence of the transfer and reading. Obviously, it is possible to use a left pixel (a pixel which has been used) as the reading capacitor of a right pixel. Although pixels in the first row may be still photosensitive at the moment of the transfer, the color cross talking that may be caused thereby is negligible since the time is short.

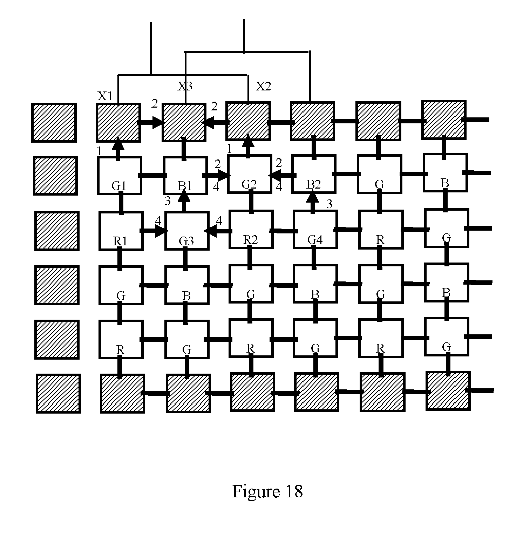

Figure 18 illustrates a schematic diagram of a subsampling reading for a photosensitive device consisted of photosensitive pixels for 2D pixel transfer according to the present disclosure. In this sub-sampling reading, charges in pixels in a same column direction are added together at first, and then sub-sampling in a row direction is implemented by line skipping. A process of charge superposition of pixels in two columns is shown, which is accomplished by the following four steps. At step 1, pixels in a first row should be reset. At step 1, pixels G1 and G2 are transferred to positions X1 and X2 in the preceding row, respectively. At step 2, pixels B1 and B2 are transferred to the position G2, while pixels X1 and X2 are transferred to the position X3 simultaneously. At step 3, pixels G3 and G4 are transferred to the positions B1 and B2 in the preceding row, respectively. At this time, the superposition of G1 and G2, as well as that of B1 and B2, can be read out. At step 4, pixels G3 and G4 in the positions B1 and B2 are transferred to the position of G2 respectively at the same time, while pixels R1 and R2 are transferred to the position G3. Thus, G3+G4 may be read from G2, and R1+R2 may be read from G3. Such a process may be then applied to following pixels circularly. Similarly, three columns may be combined together by the charge superposition. Combination of four columns may be implemented by two processes, i.e., adding and then averaging. That is, signals in columns 1 and 2 are summed, and signals in columns 3 and 4 are summed. The obtained signals are transmitted to a bus simultaneously so that a signal averaging of sums of columns 1, 2 and that of columns 3, 4 is achieved. Sub-sampling in the row direction may be implemented by applying a simple line skipping.

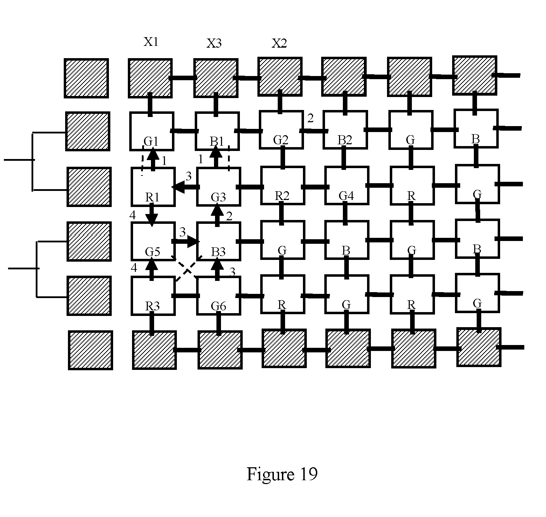

Figure 19 illustrates a schematic diagram of a sub-sampling reading by combining different colors for a photosensitive device consisted of photosensitive pixels for 2D pixel transfer according to the present disclosure. Firstly, a color sequence of YeCyYeCy... (Ye represents yellow, Cy represents cyan) is formed by successively summing pixels in a first row and a second row which are perpendicular to each other.

In particular, before being read out, pixels in the second row are transferred and combined into pixels in the first row in corresponding columns, and the combined pixels are read out immediately. After pixels in the first and second rows are processed, pixels in a third row and a fourth row are combined and sampled. Considering requirements of color reconstruction, pixels in the third and fourth rows should be cross combined when YeCy is formed by combining the first and second rows. That is, G is combined with G to form G, and B is combined with R to form Mg(magenta). To accomplish the cross combining, a complex time sequence for controlling the charge transfer is needed. For example, as shown in Figure 19, to add G5 with G6, it is possible to transfer the pixel B3 to the position G3 (step 2) and then transfer pixels G5 and G6 simultaneously to the position B3 (step 3) to implement charge superposition. At the time of the step 3, G3 may be also transferred to R1. Finally, R1 is added with R3 in the position G5 (step 4).

Figures 18 and 19 are examples for implementing the first and second combining processes disclosed in Chinese Patent Application No. 200910105948.2 titled "Multi-Spectrum Photosensitive Devices and Methods Sampling the Same" owned by the present inventor by using a photosensitive device with the new photosensitive pixels disclosed herein.

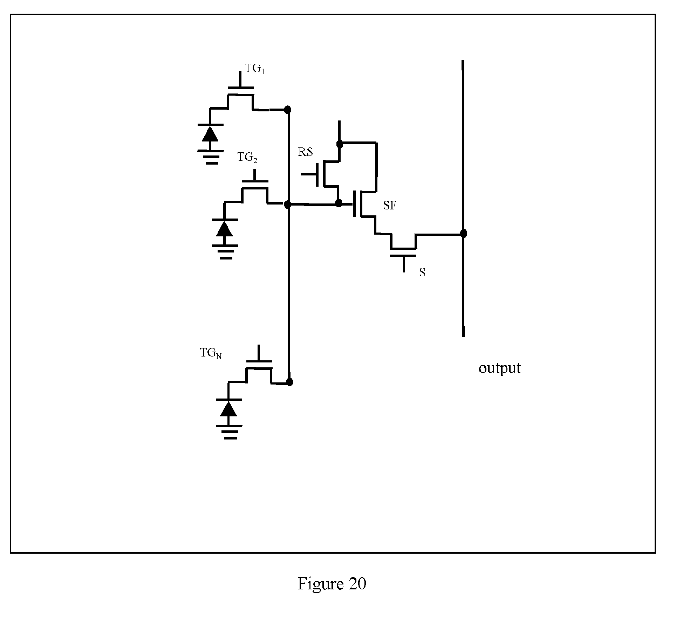

Figure 20 illustrates a shared reading circuit which can be shared by an arbitrary number of points. Conventional shared reading circuits are formed based on shared reading capacitors. That is, if a reading capacitor FD is shared by N pixels, the reading circuit is shared by the N pixels. In other words, a reading capacitor FD corresponds to a reading circuit. Since a reading capacitor FD may only be shared by pixels in its adjacency, the conventional reading circuits may only be shared by a few pixels, such as 2 points, 3 points and 4 points in a single-layer construction, or 4 points, 6 points and 8 points in a double-layer construction. However, the 2D pixel transfer photosensitive pixel of the present disclosure does not need the reading capacitor FD. As a result, it is easy to expand the number of points sharing the reading circuit to an arbitrary numeral N as desired. Certainly, if the reading circuit is shared by too many points, the effect of suppressing fixed pattern noise may not be achieved. Therefore, the value of N is determined according to an actual situation of the chip noise. Nevertheless, sharing by an arbitrary number of points is easily obtained in the circuit implementation (as shown).

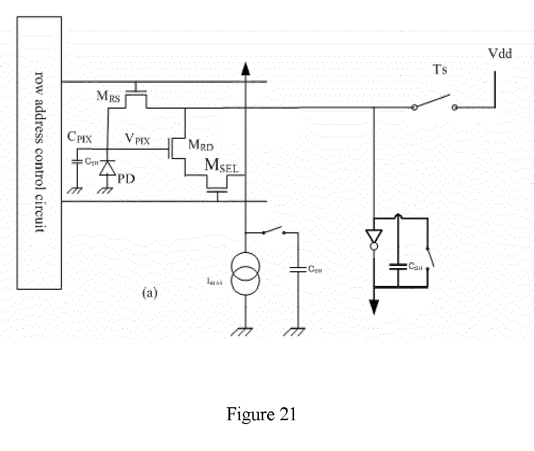

Figure 21 illustrates a schematic diagram of a hybrid reading circuit for both active and passive pixels. When the switch Ts is turned on, signals of active pixel may be obtained from an active output line. When the switch Ts is turned off, signals of passive pixel may be obtained from a passive output line. The hybrid reading circuit brings great flexibility, reduced power consumption, and an extended dynamic range, with only very few lines and space added. As stated above, the number of pixels sharing a reading circuit cannot be too large, otherwise the fixed pattern noise cannot be suppressed. One problem of active pixels is the increased power consumption and signal energy. When the power consumption is increased, temperature is also increased such that a KTC noise which is sensitive to temperature will rise. Under high illumination conditions, a saturation phenomenon may easily occur in the overall improvement of signal energy so that the dynamic range is not improved. Passive pixels have low power consumption, low signal energy, and relative large fixed pattern noise, and thus are very suitable for previewing, sub-sampling, and high illumination conditions. Therefore, users may optionally switch between the active pixel reading and the passive pixel reading depending on the application condition so as to decrease the power consumption and temperature of chips, extend the dynamic range, and improve SNR of photosensitive signals.

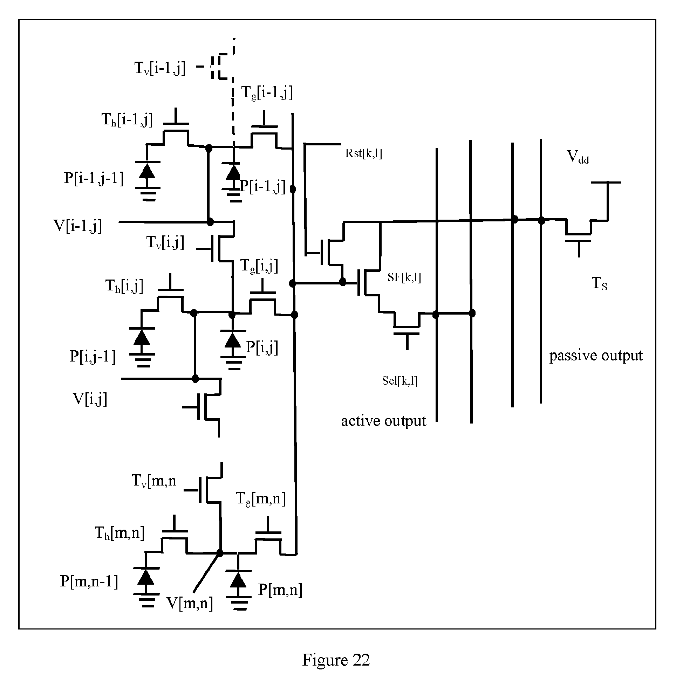

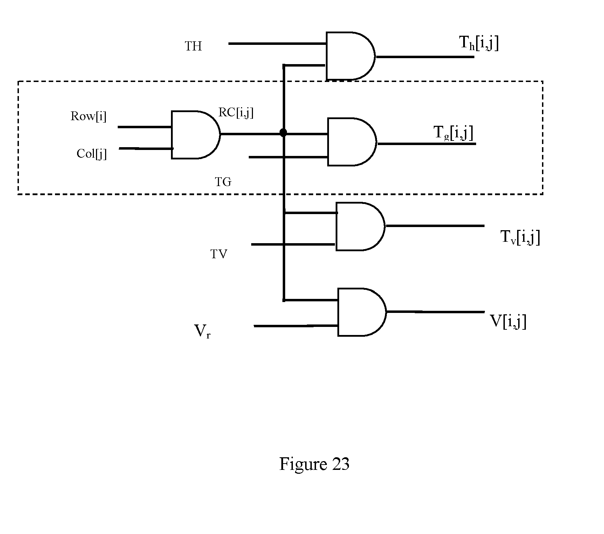

Figure 22 illustrates a case combining Figures 13, 20, and 21 together, namely, a general case in which a 2D pixel transfer photosensitive pixel is used as a basic pixel and a hybrid reading circuit with active and passive pixel functions shared by N points is employed. In the Figure 22, [i,j] is used to denote subscripts of row and column positions of a typical pixel, [k,1] is used to denote the [k,1]th reading circuit, and [m,n] is used to illustrate that pixels in different rows and columns are capable of sharing a same reading circuit. For an array photosensitive device, it is preferable that M×N pixels share one same reading circuit. As shown, each pixel P[i,j] relates to four control signals, i.e., V[i,j], Tg[i,j], Th[i,j], and Tv[i,j]. The signal V[i,j] is a bias voltage signal for resetting, pixel transfer controlling, and reading. Tg is a reading control signal, Th is a horizontal transfer control signal, Tv is a vertical transfer control signal, while Ts is a switch for selecting the active or passive pixel reading. Obviously, the four signals V, Tg, Th, and Tv should be synchronized with a row selection signal Row[i] and a column selection signal Col[j]. A gate circuit implementation of these four signals is shown in Figure 23.

Figure 23 illustrates a gate circuit implementing four signals V, Tg, Th, and Tv, wherein Row[i] is a row selection signal and Col[j] is a column selection signal, TH and TV are row and column transfer control signals respectively shared by whole device, RC[i,j] denotes a pixel selection signal, Vr is the voltage for reading. Vr is usually suspended, and turned to a high level when reading data, and turned to a low level when resetting. It can be seen from Figures 23 and 22 that each 2D pixel transfer photosensitive pixel relates to seven gates and shares a part of the shared reading circuit. This seems a large number. Actually, as long as the shared reading mode is employed, the gate circuit in the dotted line box of Figure 23 (or its equivalent circuit) is necessary. Therefore, each 2D pixel transfer photosensitive pixel uses only three more ordinary logic gates. Furthermore, Th and Tv are simple transfer gates. For semiconductor processing technology less than 130 nanometers, the space occupied by logic gates is quite smaller in relative to the reading capacitor FD.

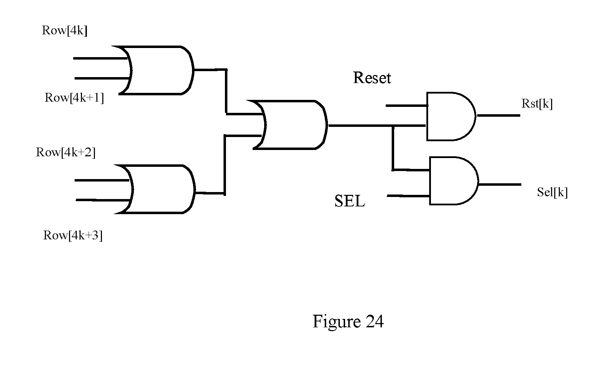

Figure 24 illustrates an implementation of a reset signal Rst[k,1] and a reading module selection signal Sel[k,1] when the reading circuit of Figure 22 is shared by 4x4 basic pixels. In this simplified implementation, both Rst[k,1] and Sel[k,1] depend on the row selection signal Row[i], but not depend on the column selection signal Col[j]. Therefore, their reference symbols may be simplified as Rst[k] and Sel[k] such that the numbers of gates needed for generating Rst[k] and Sel[k] can be ignored.

<u>Detailed Description</u>

The present disclosure includes a novel photosensitive device, a reading method and a reading circuit thereof.

According to an aspect of the present disclosure, in an exemplary photosensitive device of the present disclosure, a photosensitive pixel has a function of pixel transfer, in particular, 2D pixel transfer. In this photosensitive device, reading capacitors are eliminated. Instead, transfer gates are arranged between some or all pixels in the pixel array for connecting adjacent pixels together so that self charge of a pixel may be transferred to its adjacent pixel(s) via the transfer gate(s) under appropriate control signal timing sequence. The pixel transfer may be implemented in respective directions such as up, down, left, right directions in two dimensions. In a multilayer photosensitive device, such as a double-sided double-layer one, the pixel transfer may also be implemented between photosensitive pixels in top and bottom sides of a base layer which is arranged with a pixel array. In this case, the pixel transfer may be considered as a three-dimensional transfer since the photosensitive pixel in the top side and the bottom photosensitive pixel in the bottom side are located in different layers in the illumination direction. Herein, the charge of a pixel sensed by the pixel itself is referred to as self charge of the pixel, and the charge of the pixel transferred from pixels adjacent to the pixel is referred to as transfer charge of the pixel. That is, if pixels A and B are adjacent to each other, and the self charge of the pixel B is transferred to the pixel A, the self charge of the pixel B transferred to the pixel A is referred to as the transfer charge of the pixel A. Generally, the self charge of the pixel B may be transferred to the pixel A after the self charge of the pixel A has been read out. However, it is also possible to transfer the self charge of the pixel B to the pixel A, and then read out from pixel A the sum of the self charge and the transfer charge of the pixel A, so that charge summing of the pixels A and B is implemented. Particularly, when the transfer charges of the pixel A come from more than one adjacent pixel, such as adjacent pixels C, D in addition to the pixel B, the charge read out from the pixel A may be formed by superposition of transfer charges, such as B+C, B+D, C+D, B+C+D, or formed by superposition of the self charge of the pixel A and a plurality of transfer charges, such as A+B+C, A+B+D, A+B+C+D, and etc. It should be noticed that if the pixels involved in charge superposition have a same color, the number of the pixels may be not limited, while if the pixels are of different colors, the pixels should be of no more than two colors to conform the requirement of color reconstruction. In a word, adjacent pixels are used as reading capacitors (FD) in the present disclosure by adopting a 2D pixel transferring mode, such that reading capacitors may be omitted in a photosensitive device. Details of the reading of pixels, the reading mode of row and column scanning, the special timing control of the row and column scanning will be described below.

According to another aspect of the present disclosure, as shown in Figure 21, the reading circuit for an exemplary photosensitive device of the present disclosure may be a new reading circuit incorporated with active and passive pixels. Because passive pixels occupy small space and the reading circuit of active pixels may be shared with a plurality of pixels, it is advantageous to combine them together and selectively use them. Figure 21 shows only a simple example. There are many kinds of active pixels and many forms of multi-pixel sharing. Thus an example is used herein only to explain the basic principle of incorporating both active and passive pixels. As shown in Figure 21, when the switch Ts is closed, the reading circuit of active pixels will function, and when switch Ts is open, the reading circuit of passive pixels will function.

As described above, depending on charge transfer between pixels, the further aspect of the present disclosure implements a charge superposition of non-adjacent pixels having same or different colors. Pixels to be combined can be transferred to a same adjacent pixel which has been used and just be reset by charge transfer between pixels. As shown in Figure 18 or 19, this combination should follow very strict and accurate control timing sequence and pixel transfer direction. For example, in order to combine G1 and G2 in Figure 18, G1 and G2 should be firstly transferred to X1 and X2 respectively under the control of the timing sequence of the charge transfer, and then charges of X1 and X2 are transferred to X3 simultaneously.

The above mentioned photosensitive pixel with a 2D pixel transfer function and/or a hybrid reading mode for active and passive pixels is used as a basic photosensitive pixel, and each basic photosensitive pixel is connected with a sensing timing control circuit (including resetting), a pixel transfer control circuit and a pixel reading circuit, so that a pixel array consisted of such photosensitive pixels will have higher performance.

The reading circuit of the basic photosensitive pixels includes a passive pixel reading circuit (as shown in Figure 1), an active pixel reading circuit (as shown in Figures 2 and 3), or a hybrid active-passive pixel reading circuit (as shown in Figure 21).

A new photosensitive device may be formed by the basic photosensitive pixels arranged as follows: the basic photosensitive pixels are repeatedly arranged according to a preset pattern required for sensing single color, multicolor, or multi-spectrum including visible and infrared light.

The above-mentioned preset pattern of color of the photosensitive device may include a Bayer pattern, a honeycomb pattern, a single color pattern, and a CyYeMgX pattern, wherein X is any one of R (red), G (green), and B (blue).

The above-mentioned photosensitive device may be formed as different kinds of photosensitive devices, such as a single-sided single-layered photosensitive device, a single-sided double-layered photosensitive device, a single-sided multi-layered photosensitive device, a double-sided double-layered photosensitive device, a double-sided multi-layered photosensitive device, etc.

The sensing modes of the above-mentioned photosensitive devices include front-side sensing, backside sensing, and double-sided sensing, etc.

In an exemplary photosensitive device of the present disclosure, the sampling and sub-sampling may be performed by a signal averaging or charge superposition between pixels having same or different colors, or a hybrid signal averaging or superposition in which some combined pixels have the same color and the others have different colors.

For pixels having different colors, the sub-sampling of the photosensitive device is implemented by applying a color space conversion.

The sampling and sub-sampling circuit of the photosensitive device includes: a pixel array, a row decoder controller, a column decoder controller, a sampling control circuit, an amplifying and analog-to-digital converting module, a color converting and sub-sampling and image processing module, an output control module, a central chip control module , and other possible modules.

Output signals of the row decoder controller include a row selection signal and a row control vector signal. Output signals of the column decoder controller include a column selection signal and a column control vector signal.

In the foregoing, the sub-sampling process has been divided into a first, a second, and an optional third combining-and-sampling process. A first, second, and third combining unit corresponding to these processes respectively are employed to implement the above-mentioned combining-and-sampling processes. Certainly, these units are modules of the device just divided from the perspective of functions. Physically, these function units may be implemented in one physical module functionally, implemented in a combination of a plurality of modules, or integrated in a physical module. In a word, the first, second, and third combining units are only functionally described herein. The description thereof does not intend to limit their physical implementation.

Particularly, in the example as shown in Figure 12, a row address decoding controller and a column address decoding controller are used to implement the sub-sampling function. The row address decoding controller will output two kinds of signal, i.e., a row selection signal Row[i] (one line in each row) and a row control vector signal RS[i] (one or more lines in each row), wherein i denotes a row number. Similarly, the column address decoding controller will output two kinds of signal, i.e., a column selection signal Col[j] (one line in each column) and a column control vector signal T[j] (one or more lines in each column), wherein j denotes a column number.

The row selection signal Row[i] is used for selecting a row, while the column selection signal Col[j] is used for selecting a column. These are two sets of relatively standard signals. Row selection signal Row[i] is an expansion of existing CMOS row control signal (from a line in each row to a plurality of lines in each row), while column control vector signal T[j] does not exist in some CMOS photosensitive devices at all, even if it have, only one signal in one column.

Hereinafter, contents and effects of Row[i], Col [j], and T[j] as well as the timing sequences of these control signals in whole sampling and sub-sampling will be described with reference to an implementation as shown in Figures 22 to 24.

Figure 22 shows an implementation combining Figures 13, 20, and 21, namely, a general case in which a 2D pixel transfer photosensitive pixel is used as a basic pixel and a hybrid reading circuit with active and passive pixel functions shared by N points is employed. In the figure, [i,j] denotes subscripts of row and column position of a typical pixel, [k,1] denotes the [k,1] reading circuit, and [m,n] is used to illustrate that pixels in different row and column are capable of sharing a same reading circuit. As shown, each pixel P[i,j] relates to three control signals, i.e., Tg[i,j], Th[i,j], and Tv[i,j], wherein Tg is a reading control signal, Th is a horizontal transfer control signal, Tv is a vertical transfer control signal. In addition, Ts is a selection switch indicating active or passive pixel reading. Figure 23 shows an implementation of the three signals of Tg, Th, and Tv. Figure 24 shows a simplified implementation of Rst[k,1] and Sel[k,1] in Figure 22. That is, Rst[k,1] and Sel[k,1] are simplified as Rst[k] and Sel [k] independently from Col[j].

Except for Row[i] and Col[j], in this implementation, there are seven overall control signals which are Reset, SEL, TH, TV, TG, Vr, and Ts. Ts may be controlled by a central chip control module CC. Reset, SEL, and TV may be grouped into RS[i], while Vr, TH, and TG may be grouped into T[j]. Such classification is not unique.

There are two methods for signal reading in full frame sampling. One is using the pixel in the front row as a reading capacitor; the other is using the left (or right) pixel having been read out as a reading capacitor. Timing sequence in the former situation is simpler, the operation process of which will be described simply as below. As shown in Figure 17, the row and column addresses of R1 are set as [i,j], and the timing sequence of control signal for reading R1 is as follow:

1. Clock t0: The pixel G1 above R1 is reset. At the rising edge of the clock, Row[i-1] and Col[j] are set to select address of G1, and Rst[i-1] is set to zero at this moment. At the next moment, Rst[i-1] will be raised to high level. At the falling edge of the clock, zero value of G1 may keep being readout to perform coherent sampling. That is, SEL is turned off at this time and then the charge of G1 will be readout.

2. Clock t1: The charge of R1 is transferred to G1 and readout at the same time. At the rising edge of the clock, Row[i-1] and Col[j] are set to select the address of R1, and TV is pulled to high level. At the falling edge of the clock, Row[i-1] and Col[j] are set to select the address of G1, and SEL is turned off to read the charge of G1.

Other pixels will be readout repeatedly in this way. Preferably, Ts may be closed to read active pixel during the full frame reading.

During sub-sampling, the timing sequence of the control signal may be extremely complex according to sampling factor M×N, combining modes of the selected pixels and the pattern distribution of single- or double-layered photosensitive pixels. However, a digital circuit is able to manage all cases because one chip only needs to deal with several cases. Two examples will be taken to explain the principle of implementing pixels combination by transferring pixels. The relationship among control signals applies the implementation modes as shown in Figures 22 to 24. These implementation modes are exemplarily illustrated, but not limited thereto.

In the case of combining interlaced pixels as shown in Figure 18, the row and column addresses of G1 are set as [i,j], and combination of G1 and G2 may be accomplished by the following timing sequence of control signals.

1. Clock t0: X1, X2, and X3 are reset. At the rising edge of the clock, Row[i-1], Col[j], Col[j+1], and Col [j+2] are set to select addresses of X1, X2, and X3, and Rst[i-1] is set to zero. At the next moment, Rst[i-1] will be pulled to high level.

2. Clock t1: G1 and G2 are transferred to X1 and X2 respectively. At the rising edge of the clock, Row[i], Col[j], and Col[j+2] are set to select addresses of G1, G2, and TV is pulled to high level.

3. Clock t2: X1, and X2 are transferred to X3. At the rising edge of the clock, Row[i-1] and Col[j] are selected at first and then Vr is set to high level. At the same time, X3 is in the state of receiving charges to be transferred. At the falling edge of the clock, Row[i-1], Col[j+1], and Col[j+2] are set to select addresses of X1, and X2, and TH is pulled to high level, so that charge of X1 is transferred rightward to X3, while charge of X2 is transferred leftward into X3.

4. Clock t3: The signal of X3 is read out. At the rising edge of the clock, Row[i-1], and Col[j+1] are set and TG is pulled to high level (at this moment Vr is still in high potential).

It is very simple to readout B1 and B2 after G2 has been read out.

5. Clock t2: Charges of B1 and B2 are transferred to G2. At the rising edge of the clock, Row[i], and Col[j+2] are selected at first and Vr is pulled to high level. At this moment, G2 is in the state of receiving transferred charges. At the falling edge of the clock, Row[i], Col[j+2] and Col[j+3] are set to select addresses of G2 and B2, and then TH is pulled to high level, so that charge of B1 is transferred rightward to G2, while charge of B2 is transferred leftward to G3.

6. Clock t3 or t4: The signal of G2 is readout. At the rising edge of the clock, Row[i], and Col[j+2] are selected and TG is pulled to high level (at this moment, Vr is still in high potential). If signal is read out at clock t3, the device should be capable of reading two data simultaneously, i.e., have two amplification and AD conversion circuits.

The case of two-row combining and cross-combining is shown in Figure 19, in which the combination of row G1 land row R1 may be accomplished in one same clock, namely, pixels of row R1 may be simultaneously transferred to the row located immediately above it . This case is very simple and the timing sequence of control signal will not be described in detail. Setting the row and column addresses of G5 as [i,j], the combination of G5 and G6, as well as the combination of B3 and R3 may be accomplished by the following timing sequence of control signals:

1. Clock t0: R1 and G3 are reset. At the rising edge of the clock, Row[i-1], Col[j], and Col[j+1] are set to select addresses of R1 and G3, and at this moment Rst[i-1] is set to zero. At the next moment, Rst[i-1] will be pulled to high level.

2. Clock t1: B3 is transferred to G2. At the rising edge of the clock, Row[i] and Col[j+1] are set to select addresses of B3, and TV is pulled to high level.

3. Clock t2: G5 and G6 are transferred to B3, and G3 is transferred to R1. At the rising edge of the clock, Row[i] and Col[j+ 1] are selected at first and then Vr and TH are pulled to high level. At the same time, X3 is in the state of receiving transferred charges, and charge of G5 is transferred leftward to B3. At the falling edge of the clock, Row[i-1], and Col[j+1] are selected and then TV is pulled to high level, so that charge of G5 is transferred upward into B3.

4. Clock t3: The signal of B3 (original G5+G6) is read out, and charges of R1 and R3 are transferred to G5. At the rising edge of the clock, Row[i] and Col[j+1] are set and TG is pulled to high level (at this moment Vr is still high). At this moment, B3 is read out. At the falling edge of the clock, Row[i], Row[i+1], and Col[j] are set, and TV is pulled to high. At this moment, charge of R1 is transferred downward to G5, and charge of R3 is transferred upward to G5.

5. Clock t4: The signal of G5 (original B3+R3) is read out. At the rising edge of the clock, Row[i] and Col[j] are set and TG is pulled to high level (at this moment Vr is still high). At this moment, G5 has been read out.

The above-mentioned cross-combining process is troublesome, but it is not too complex.

During sub-sampling, for each supported M×N sampling factor (one row is to be reduced by M times, one column is to be reduced by N times), according to the sampling factor M×N and the image area requirement, a row decoder controller and a column decoder controller set values of all Row[i] and RS[i] of the rows, which are needed to be combined corresponding to each output row, to high or low simultaneously, and then set values of all Col[j] and T[j] of the columns, which are needed to be combined corresponding to each output column, to high or low simultaneously, such that values (charge/voltage) of all pixels to be combined can be transferred to other pixels sequently. The values will be output to an output bus in accordance with reading order (via a reading circuit) following the charge combining. Meanwhile, if necessary, the row decoder controller and the column decoder controller also perform necessary operation of row or column skipping or abandon redundant colors according to the sampling factor M×N and the image area requirement.

For different M×N sampling factors, different colors may be obtained on the output bus in different time. Accordingly, other functional modules, such as amplifying and analog-to-digital conversion modules, color conversion and sub-sampling and image process modules, and output control modules may be needed to coordinate correspondingly. The total control of this system may be performed by a central chip control module (CC module in Figure 12). It should be noted that most modules except for the amplifier and analog-to-digital conversion module and the pixel array are digital process circuits, and thus may be implemented in the peripheral of devices easily so that the wiring of photosensitive device is simplified.

In the present application, it is possible to simultaneously select several rows, several columns, or several rows and columns. Although several rows or columns are selected simultaneously in some previous technologies (such as U.S. Patent Nos. US6,801,258B1, US6,693,670B1, US7,091,466B2, US7,319,218B2, and etc.), the timing sequences and wave patterns of the row selection signal and the column selection signal are different since the combining-and-sampling methods are different. For example, during the second combining-and-sampling in Figure 18, when the first and third columns of the first row are selected simultaneously, data in the two columns are not output immediately to the output bus, but are transferred simultaneously to the pixels (photostable dumb pixels) in the first and third columns of the immediately previous row. This situation never occurs in the sub sampling in the prior arts.

More particularly, during sub sampling with any $M \times N$ factors ($M \geq 2$, $N \geq 2$), a first combining-and-sampling process in which two rows, or two columns, or two rows and two columns are combined and sampled is performed at first, and then a sub-sampling of M rows xN columns is performed based on the first combining-and-sampling process.

The sub-sampling after the first combining-and-sampling process, i.e., a second combining-and-sampling process, may be performed by any one or combination of the following ways: automatic averaging signals output to a bus directly, row skipping or column skipping, or one by one sampling. However, a third combining-and-sampling process, if any, may be accomplished by one or combination of the following two ways: color space converting and backend digital image scaling.

It is known that there are quite a lot of photosensitive pixels in a pixel array. Especially for a double-layer or multi-layer photosensitive device, there are many types of colors which have different geometric distributions. Obviously, the first combining-and-sampling process is directed to a plurality of first combined pixels (i.e., the pixels combined during the first combining-and-sampling process. This concept is used to represent the pixels obtained after the first combining process. For example, if self-charge of pixel B is transferred to pixel A during the first combining-and-sampling process, both self-charge of pixel A and transfer charge from pixel B exist in pixel A, and the first combined pixel is the superposition sampling data A+B existing in pixel A. However, it should be noted that it does not imply that "a first combined pixel" is physically present in pixel array). Thus during the first combining-and-sampling process, color selections for combining these first combined pixels are various from the perspective of color combining of pixel, including combining same color, combining different colors, hybrid combining (some pixels have the same color, the others have different colors), or selectively abandoning redundant colors

Color space conversion includes a conversion from RGB to CyYeMgX space (X is one of R, G and B), a conversion from CyYeMgX to YUV space, and a conversion from RGB to YUV space.

It should be noted that the conversion from RGB to CyYeMgX space may be accomplished in an analogue signal space or in a digital space. Therefore, this conversion may be performed in any one of the first, the second, or the third combining-and-sampling process. However, the conversions from CyYeMgX to YUV space and that from RGB to YUV space may only be accomplished in a digital signal space, i.e., in the third combining-and-sampling process.

More particularly, a pixel array consists of a plurality of macro-pixels arranged in a square array, in which two, three or four basic pixels are in a group. The basic pixel in a macro-pixel may be passive pixels, or 3T, 4T, 5T, or 6T active pixels without FD (referring to "CMOS/CCD Sensor and Camera Systems", Gerald C. Holst and Terrence S. Lomheim, JCD Publishing, ISBN: 980970774934, 2007, pp. 99-101). Each basic pixel may be a single-sided single-layer, single-sided dual-layer, dual-sided dual-layer, or dual-sided multi-layer compound pixel. That is to say, one basic pixel comprises one or more basic pixel cells, each of which are layered along lighting direction and may be distributed on the top and/or bottom side of a substrate of the photosensitive pixel.

The reading circuit for a basic photosensitive pixel consisted of active pixels may employ an N-point sharing mode (as shown in Figure 20) in addition to the existing non-sharing mode, 4-point sharing mode, 6-point sharing mode and 8-point sharing mode.

For the dual-layer or multi-layer photosensitive devices, besides more abundant color selection in the first combining-and-sampling process, the shared sampling circuit and color combining mode are more plentiful. In addition, many patterns may easily apply the charge superposition during the combining-and-sampling of the first row and the first column (referring to Chinese Patent Application No. 200910105948.2 titled "Multi-Spectrum Photosensitive Device and Sampling Method Thereof').

It should be noted that the upper limit of SNR improvement is N 4i times when N signals are combined by applying the charge superposition, while the upper limit of SNR improvement is only $\sqrt{N}$ times when N signals are combined by signal averaging. As a result, the charge superposition is one of the most optimal ways of sub-sampling.

Digital signals of photosensitive pixels will be stored in a buffer and further processed by the color conversion and sub-sampling module and the image process module. In the case of full sampling, no sub-sampling is performed and generally no color conversion is performed for large array image sensing devices. Therefore, the central chip control module CC may conduct corresponding control under this mode, so that the digital signals of photosensitive pixels may skip the color conversion and sub-sampling module and go directly into the image process module. Following image processing in photosensitive devices, the digital signals may be output to an external interface of the photosensitive device via an output module.

It is more complex during sub-sampling, but it is possible that only few M×N sub-sampling factors are supported for a specific photosensitive device. Accordingly, the central chip control module CC, the row decoder controller, and the column decoder controller may only consider the supported M×N sub-sampling factors. For example, a 5 million-pixel photosensitive device may only consider four cases of 2×2, 2×1, 4×4, and 8×8.

The second combining-and-sampling process generally does not involve charge superposition, and the following three ways are usually applied: automatic averaging of signals output directly to a bus, row skipping or column skipping, or one by one sampling. The three ways are conventional and simple, and are well known for the skilled in the art. Thus the description thereof will be omitted. The third combining-and-sampling process may be accomplished in digital image space by employing digital image scaling technology which is relative standard.

The central chip control module CC may calculate the color of the pixels being readout at different time during sampling, and perform corresponding process. For the selected pixel sampling order, the central chip control module CC may control the amplifier and analog-to-digital conversion module correspondingly to transfer different colors through different amplifier circuits to the color conversion and sub-sampling module and the image process module, as well as the output control module, so that different colors may be processed differently. The description in more detail goes beyond the scope of the present application.

The prior sub-sampling is mainly carried out between pixels of the same color, and mainly achieved by pixel averaging and row skipping or column skipping. These methods may not work for dual-photosensitive devices or multi-photosensitive devices. The sub-sampling method proposed in the present application may be carried out by the way of color space conversion between pixels of the same color or of different colors. Alternatively, the sub-sampling method proposed in the present application may be carried out in hybrid (i.e., a part of the sub-sampling is performed between pixels of the same color, while the remainder is performed between pixels of different colors). Moreover, according to the signal combining of charge superposition proposed in the present application, the effect of summing $N^3$ signals may be almost achieved by combining only N signals. Therefore, the sub-sampling method in the present application will produce higher image quality compared to a typical sub-sampling method in the prior art. In particular, when the present application is employed for double-layer photosensitive devices or multi-layer photosensitive devices, a large number of simple and excellent sub-sampling ways will be generated.

The foregoing is provided for illustrating the essence and scope of the present application by single-layer and dual-layer photosensitive devices and some embodiments. These specific conditions are not intended to limit the present application. Rather, if the present application is used for more complicated designs, such as 5T/6T active pixels or a multi-layer photosensitive device, the advantageous effects will be more apparent.

**Claims**

1. A photosensitive device comprising a pixel array and a reading circuit, wherein a transfer gate for connecting adjacent pixels and transferring charge between the connected pixels is arranged among at least some designated pixels in the pixel array, the read circuit is used for reading charge of a pixel in the pixel array, said charge is at least one of self-charge of said pixel, charge transferred from an adjacent pixel of said pixel, superposition of the self-charge of said pixel and the charge transferred from one or more pixels adjacent to said pixel, and superposition of the transfer charges of two or more pixels adjacent to said pixel.

2. The photosensitive device of claim 1, wherein the adjacent pixels connected to one pixel in said a part of pixels via the transfer gate comprise four adjacent pixels which are above, below, leftward and rightward to said one pixel respectively.

3. The photosensitive device of claim 1 or 2, wherein a transfer gate is arranged between each two pixels of the pixel array.

4. The photosensitive device of any one of claims 1 to 3, wherein the reading circuit reads the self-charge of a pixel connected thereto, resets the self-charge of the pixel, and then reads the charge transferred from pixels adjacent to the pixel.

5. The photosensitive device of any one of claims 1 to 4, wherein the reading circuit includes an active pixel reading circuit, a passive pixel reading circuit, or a hybrid active-passive pixel reading circuit.

**6.** The photosensitive device of claim 5, wherein the active pixel includes a 3T, 4T, 5T, or 6T active pixel.

**7.** The photosensitive device of any one of claims 1 to 6, wherein the reading circuit is shared by 4, 6, 8 or arbitrary number of points or not shared by points.

**8.** The photosensitive device of claim 7, wherein a transfer distance from a pixel in a set of pixels sharing one reading circuit which is disconnected to the reading circuit to a pixel in the set which is connected to the reading circuit is not longer than four pixels when the reading circuit is shared by 4, 6, 8 or arbitrary number of points.

**9.** The photosensitive device of any one of claims 1 to 8, wherein the photosensitive device comprises a single-sided single-layer photosensitive device, a single-sided double-layer photosensitive device, a single-sided multi-layer photosensitive device, a double-sided double-layer photosensitive device, and a double-sided multilayer photosensitive device.

**10.** The photosensitive device of any one of claims 1 to 9, wherein the photosensitive device is sensed in a method of front-side sensing, backside sensing or double-sided sensing.

**11.** The photosensitive device of any one of claims 1 to 10, wherein pixels in the pixel array are repeatedly arranged according to a preset pattern for sensing single color, multi-color, or multi-spectrum including visible light and infrared light.

**12.** The photosensitive device of claim 11, wherein the preset pattern includes Bayer pattern, honeycomb pattern, single color pattern or CyYeMgX pattern wherein X is any one of red, green, and blue.

**13.** A reading method for a photosensitive device, including:

arranging among at least some designated pixels in a pixel array a transfer gate for connecting adjacent pixels and transferring charge between the connected pixels;
reading charge of a pixel in the pixel array, wherein the charge is at least one of self-charge of said pixel, charge transferred from an adjacent pixel of said pixel, superposition of the self-charge of said pixel and the charge transferred from one or more pixels adjacent to said pixel, and superposition of the transfer charges of two or more pixels adjacent to said pixel.

**14.** The reading method of claim 13, wherein the charge transferred from pixels adjacent to the pixel is read out after the self-charge of the pixel is read out and reset.

**15.** The reading method of claim 13 or 14, including a sampling and sub-sampling process which comprises:

a first combining process for combining-and-sampling two neighboring pixels in the pixel array which are in a same row but different columns, different rows but a same column, or different rows and different columns to obtain sampling data of a first combined pixel; and
a second combining process for combining-and-sampling the sample data of the first combined pixel resulted in the first combining process to obtain sampling data of a second combined pixel.

**16.** The reading method of claim 15, further including a third combining process for combining-and-sampling the sampling data of the second combined pixel resulted in the second combining process to obtain sampling data of a third combined pixel.

**17.** The reading method of claim 15 or 16, wherein the first or second combining process is performed by a charge superposition of pixels with same or different colors or a signal averaging of pixels with different colors, wherein pixels with different colors are combined according to a color space conversion to meet requirements of color reconstruction.

**18.** The reading method of any one of claims 15 to 17, wherein combining-and-sampling based on color performed in the first or the second combining process includes same-color combining, different-color combining, hybrid combining, or selectively abandoning redundant colors, and at least one of the first and the second combining process is not performed by the same-color combining.

**19.** The reading method of any one of claims 15 to 17, wherein combining-and-sampling based on position performed in the first or the second combining process includes at least one of automatic averaging of signals output directly to a bus, row skipping or column skipping, and one-by-one sampling.

**20.** The reading method of any one of claims 15 to 19, wherein the third combining process is performed by at least one of color space conversion and backend digital image scaling.

**21.** The reading method of any one of claims 17 to 20, wherein the color space conversion includes a conversion from RGB to CyYeMgX space, a conversion from RGB to YUV space, or a conversion from CyYeMgX to YUV space, wherein X is any one of R, G and B.

**22.** The reading method of any one of claims 15 to 21, wherein sampling of a whole image is performed by progressive scanning progressive reading or progressive scanning interlacing reading.

**23.** A reading circuit of a photosensitive device for reading charge of a pixel in a pixel array of the photosensitive device, wherein a transfer gate for connecting adjacent pixels and transferring charge between the connected pixels is arranged among at least some designated pixels in the pixel array, the read circuit is used for reading charge of a pixel in the pixel array, said charge is at least one of self-charge of said pixel, charge transferred from an adjacent pixel of said pixel, superposition of the self-charge of said pixel and the charge transferred from one or more pixels adjacent to said pixel, and superposition of the transfer charges of two or more pixels adjacent to said pixel.

**24.** The reading circuit of claim 23, wherein the reading circuit connected to at least some designated the pixels in the pixel array is a hybrid reading circuit of both active pixel and passive pixel.

**25.** The reading circuit of claim 23 or 24, wherein the reading circuit is provided with a pixel clear or reset signal.

Figure 1

Figure 2

Figure 3

Figure 4

Figure 5

Figure 6

Figure 7

EP 2 521 178 A1

(a)

charge to voltage conversion

(b)

Figure 8

Figure 9

Figure 10

Figure 11

Figure 12

transfer gate

V[i,j]

pixel

（a）

$T_v[i,j]$

$T_h[i,j]$

P[i,j]

（b）

Figure 13

non-sensing pixel     photosensitive pixel     transfer gate

Figure 14

Figure 15

Figure 16

Figure 17

Figure 18

Figure 19

Figure 20

Figure 21

Figure 22

Figure 23

Row[4k]

Row[4k+1]

Row[4k+2]

Row[4k+3]

Reset

Rst[k]

SEL

Sel[k]

Figure 24

# INTERNATIONAL SEARCH REPORT

| International application No. |
|---|
| PCT/CN2010/073442 |

**A.  CLASSIFICATION OF SUBJECT MATTER**

See extra sheet
According to International Patent Classification (IPC) or to both national classification and IPC

**B.   FIELDS SEARCHED**

Minimum documentation searched (classification system followed by classification symbols)

IPC: H01L; H04N

Documentation searched other than minimum documentation to the extent that such documents are included in the fields searched

Electronic data base consulted during the international search (name of data base and, where practicable, search terms used)

WPI; EPODOC; CNKI; CPRS

photosensitive, pixel, charge, transfer, gate, superimposition, adjacent, array, read (and the like)

**C.   DOCUMENTS CONSIDERED TO BE RELEVANT**

| Category* | Citation of document, with indication, where appropriate, of the relevant passages | Relevant to claim No. |
|---|---|---|
| E | CN101853861A (BOLI MALJIE COMMUNICATION SHENZHEN CO LTD) 06 Oct. 2010 (06.10.2010) Claims 1-25 and paragraphs 91-97 of the description | 1-25 |
| X | US2009046189A1 (MICRON TECHNOLOGY INC) 19 Feb. 2009 (19.02.2009) Claims 1-16 and paragraphs 20-37 of the description | 1-14,23-25 |
| A | The whole document | 15-22 |
| A | CN101123670A (UNIV DONGBEI) 13 Feb. 2008 (13.02.2008) the whole document | 1-25 |

| ☐ Further documents are listed in the continuation of Box C. | ☒ See patent family annex. |
|---|---|

| * | Special categories of cited documents: |
|---|---|
| "A" | document defining the general state of the art which is not considered to be of particular relevance |
| "E" | earlier application or patent but published on or after the international filing date |
| "L" | document which may throw doubts on priority claim (S) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
|---|---|
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
|---|---|
| 17 Feb. 2011 (17.02.2011) | **10 Mar. 2011 (10.03.2011)** |

| Name and mailing address of the ISA/CN The State Intellectual Property Office, the P.R.China 6 Xitucheng Rd., Jimen Bridge, Haidian District, Beijing, China 100088 Facsimile No. 86-10-62019451 | Authorized officer ZHOU, Shuhong Telephone No. (86-10)62411693 |
|---|---|

Form PCT/ISA /210 (second sheet) (July 2009)

## INTERNATIONAL SEARCH REPORT
Information on patent family members

| International application No. |
| --- |
| PCT/CN2010/073442 |

| Patent Documents referred in the Report | Publication Date | Patent Family | Publication Date |
| --- | --- | --- | --- |
| CN101853861A | 06.10.2010 | None | |
| US2009046189A1 | 19.02.2009 | WO2009026048A1 | 26.02.2009 |
| | | TW200931651A | 16.07.2009 |
| | | GB2465712A | 02.06.2010 |
| | | CN101809744A | 18.08.2010 |
| CN101123670A | 13.02.2008 | None | |

Form PCT/ISA /210 (patent family annex) (July 2009)

## INTERNATIONAL SEARCH REPORT

International application No.

PCT/CN2010/073442

A. CLASSIFICATION OF SUBJECT MATTER

H01L 27/144 (2006.01)i
H04N 5/335 (2011.01)i

According to International Patent Classification (IPC) or to both national classification and IPC

Form PCT/ISA /210 (extra sheet) (July 2009)

**EP 2 521 178 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 2007071262 W
- CN 200810217270
- CN 200910105948
- US 6801258 B1
- US 6693670 B1
- US 7091466 B2
- US 7319218 B2

**Non-patent literature cited in the description**

- Silicon infrared focal plane arrays. **M. KIMATA.** Handbook of Infrared Detection Technologies. Elsevier Science Ltd, 2002, 352-392
- **GERALD C. HOLST ; TERRENCE S. LOMHEIM.** CMOS/CCD Sensor and Camera Systems. JCD Publishing, 2007, 99-101